# EUROPÄISCHE PATENTANMELDUNG

(11) **EP 4 733 792 A1**
(43) Veröffentlichungstag der Anmeldung: **29.04.2026**
(21) Anmeldenummer: 25209094.9
(22) Anmeldetag: 16.10.2025
(51) Int. Cl.: G01R 31/69, G01R 31/58

(54) **PRÜFSYSTEM ZUR PRÜFUNG VON KABELSÄTZEN SOWIE PRÜFMODUL FÜR EIN SOLCHES PRÜFSYSTEM**

(30) Priorität: 25.10.2024 DE 102024210326
(71) Anmelder: LEONI Bordnetz-Systeme GmbH, 97318 Kitzingen (DE); LEONI Wiring Systems Slovakia spol. s r.o., 911 01 Trencin (SK); Leoni Wiring Systems UK Limited, Newcastle-under-Lyme, Staffordshire ST5 9BT (GB)
(72) Erfinder: EGBERS, Andreas, 97340 Marktbreit (DE); KALIANKO, Imrich, 91101 Trencín (SK); MATAVA, Lubomir, 911 01 Trencin (SK); RAHMAN, Mehbub-Ur, 97318 Kitzingen (DE); WEBB, Robert, Stoke-On-Trent ST6 8HL (GB); YEOLE, Aniket, 97318 Kitzingen (DE)
(74) Vertreter: FDST Patentanwälte

(57) **Zusammenfassung**

Das Prüfsystem zur Prüfung von Kabelsätzen (4) weist eine Prüfvorrichtung (2) auf, in die mehrere Prüfmodule (6) einsetzbar sind, wobei an jedes Prüfmodul (6) ein Stecker (12) des zu prüfenden Kabelsatzes (4) einsteckbar ist, wobei die Prüfmodule (6) modular aufgebaut sind mit einem Basisteil (22) und einem daran über eine Schnittstelle (20) austauschbar befestigten steckerspezifischen Aufsatz (24). Durch den modularen Aufbau ist eine einfache Anpassung des modularen Prüfmoduls (6) an unterschiedliche Stecker (12) und damit auch eine Anpassung an unterschiedliche Kabelsätze (4) mit geringem Aufwand ermöglicht. Die im Basisteil (22) enthaltenen Komponenten können für verschiedene Kabelsätze wiederverwertet werden.

## Beschreibung

Die Erfindung betrifft ein Prüfsystem zur Prüfung von Kabelsätzen sowie ein Prüfmodul für ein solches Prüfsystem.

Bei der Herstellung von Kabelsätzen beispielsweise für Kraftfahrzeuge werden die Kabelsätze üblicherweise am Ende der Kabelsatzfertigung auf ihre Funktionsfähigkeit hin überprüft. Dies erfolgt üblicherweise mithilfe von speziellen Prüfvorrichtungen, die auch als Prüftische bezeichnet werden.

Eine jeweilige Prüfvorrichtung weist hierzu eine Vielzahl von Modulen auf, in die jeweils ein Stecker des Kabelsatzes eingesteckt werden kann. Über die Prüfmodule werden die einzelnen Leitungen des Kabelsatzes überprüft, speziell wird jede einzelne Leitung des Kabelsatzes durch eine Widerstandsmessung überprüft.

Die Prüfmodule werden spezifisch für einen jeweiligen Kabelsatz hergestellt, wobei ein jeweiliges Prüfmodul insbesondere auch eine steckerspezifische Aufnahme aufweist. Wird der Kabelsatz beispielsweise am Ende einer Serienfertigung nicht mehr hergestellt, so werden die Prüfmodule nicht mehr benötigt und entsorgt. Speziell bei Kleinserien sind die Kosten für die Herstellung der kabelsatz-spezifischen Prüfmodule nicht unerheblich.

Zur Vereinfachung der Herstellung von Prüfmodulen ist beispielsweise aus der DE 10 2005 017 241 B3 ein Prüfmodul zu entnehmen, welches einen Steckeraufnehmer aufweist, dessen steckerspezifische Aufnahme an unterschiedliche Stecker anpassbar ist.

Aus der EP 3 872 512 A1 ist ein Kabelsatz mit angeschlossenen Steckern zu entnehmen, an die Teststecker zu Prüfzwecken anschließbar sind, die t, jeweils mit einem Mikrocomputer verbunden sind, welcher über eine drahtlose Verbindung mit einem zentralen Rechner verbunden ist.

Ausgehend hiervon liegt der Erfindung die Aufgabe zugrunde, ein verbessertes modulares Prüfsystem zur Prüfung von Kabelsätzen sowie ein modular aufgebautes Prüfmodul für ein solches Prüfsystem anzugeben.

Die Aufgabe wird gemäß Erfindung gelöst durch ein Prüfsystem mit Merkmal des Anspruchs 1 sowie durch ein Prüfmodul mit den Merkmalen des Anspruchs 14 sowie durch ein Prüfmodul-Set mit den Merkmalen des Anspruchs 15. Die im Hinblick auf das Prüfsystem angeführten Vorteile und bevorzugten Ausgestaltungen sind sinngemäß auch auf das Prüfmodul und das Prüfmodul-Set zu übertragen.

Das erfindungsgemäße Prüfsystem zur Prüfung von Kabelsätzen umfasst eine Prüfvorrichtung, beispielsweise einen sogenannten Prüftisch, in die mehrere Prüfmodule einsetzbar sind. Die Prüfvorrichtung weist hierzu typischerweise ein Gestell auf, in welches die Prüfmodule an unterschiedlichen (Raster-) Plätzen positionierbar sind, sodass eine Anpassung an unterschiedliche Kabelsätze möglich ist. In jedes Prüfmodul ist ein Stecker des zu prüfenden Kabelsatzes einsteckbar. Die Prüfmodule sind modular aufgebaut mit einem Basisteil und einem daran über eine Schnittstelle austauschbar befestigten steckerspezifischen Aufsatz.

Der Aufsatz weist folgende Merkmale auf:
- Eine steckerspezifische Aufnahme, in die der Stecker einsteckbar ist,
- eine Vielzahl von insbesondere als Prüfstifte ausgebildeten Prüfkontakten zur elektrischen Prüfung von Leitungen des Kabelsatzes, wobei die Prüfkontakte üblicherweise in einem gemeinsamen Träger gehalten sind.
- In bevorzugter Weiterbildung weist der Aufsatz weiterhin zumindest eine Pneumatikleitung auf, die zur Druckluftversorgung eines in den Aufsatz integrierten Pneumatikelements dient, welches beispielsweise als
Ansteuerelement für die Betätigung einer mechanischen Verriegelung ausgebildet ist.

Das Basisteil weist folgende Merkmale auf:
- Eine Mehrzahl von Testpunktanschlüssen, über die für die Prüfung jeweils einer Leitung Prüfsignale bereitgestellt werden, und die mit den Prüfkontakten elektrisch verbindbar sind,
- eine Steuereinheit, die insbesondere zumindest zur Prüfung von Zuständen des Prüfmoduls ausgebildet ist, beispielweise zur Prüfung einer Verriegelung oder zur Prüfung von im Prüfmodul verbauten Sensoren oder Schaltern, wobei bei sogenannten intelligenten Prüfmodulen die Steuereinheit ergänzend oder alternativ zur Steuerung eines Prüfablaufs und zur Abgabe und Auswertung der Prüfsignale ausgebildet ist. Bei der Steuereinheit handelt es sich beispielsweise um eine speicherprogrammierbare Steuerung (PLC / SPS),
- Weiterhin weist das Basisteil gemäß einer bevorzugter Weiterbildung eine Ventileinheit mit zumindest einem pneumatischen Ventil zur Versorgung der Pneumatikleitung im Aufsatz auf.

Der Aufsatz und das Basisteil sind allgemein zumindest über elektrische Verbindungsleitungen miteinander verbunden, speziell sind über die elektrischen Verbindungsleitungen zumindest ausgewählte Testpunktanschlüsse (steckerspezifisch) mit den Prüfkontakten verbunden.

Die Schnittstelle weist ein basisseitiges Schnittstellenteil sowie ein aufsatzseitiges Schnittstellenteil auf, über die eine lösbare elektrische Steckverbindung für vorzugsweise sämtliche elektrische Verbindungsleitungen zwischen dem Aufsatz und dem Basisteil ausgebildet ist. Das basisseitige Schnittstellenteil ist dabei insbesondere an einer Oberseite des Basisteil und das aufsatzseitige Schnittstellenteil ist an einer Unterseite des Aufsatzes angebracht. Der Aufsatz wird vorzugsweise auf das Basisteil aufgesteckt und hierdurch wird die elektrische Steckverbindung ausgebildet.

Durch die modulare Ausgestaltung und durch die Aufteilung zum einen in den Aufsatz und zum anderen in das Basisteil ist eine einfache Anpassung des modularen Prüfmoduls an unterschiedliche Stecker ermöglicht. Aufgrund der Integration der komplexen und aufwändigen Bauteile in das Basisteil (beispielsweise die Sensorik, das in bevorzugter Ausgestaltung vorgesehene zumindest eine pneumatische Ventil sowie die Steuereinheit) wird der besondere Vorteil erreicht, dass diese teuren und komplexen Bauteile für unterschiedlich konfigurierte Prüfmodule herangezogen und damit wiederverwertet werden können, auch für unterschiedliche Kabelsätze. Es braucht lediglich der Aufsatz angepasst und ausgetauscht werden.

Demgegenüber weist der Aufsatz einen vergleichsweise einfachen Aufbau auf und ist insbesondere frei von Auswerteeinheiten oder Steuereinheiten. Für eine Anpassung an unterschiedliche Stecker und unterschiedliche Kabelsätze braucht daher lediglich der Aufsatz angepasst werden. Die Schnittstelle, insbesondere das basisseitige Schnittstellenteil ist demgegenüber vorzugsweise steckerunabhängig, also zumindest für Basisteile eines gleichen Typs identisch. Eine steckerspezifische Konfiguration erfolgt daher über das Design des aufsatzseitigen Schnittstellenteils. Insbesondere erfolgt dies durch eine gezielte Auswahl, welche der Testpunktanschlüsse des Basisteils mit den Prüfkontakten des Aufsatzes verbunden werden.

Beim Basisteil handelt es sich daher um ein standardisiertes und universell für eine Vielzahl von unterschiedlichen Steckern einsetzbares Basisteil, so dass die Basisteile für unterschiedliche Kabelsätze wiederverwendet werden können. Durch diese Wiederverwendung ist der Kostenaufwand für die Bereitstellung der kabelsatzspezifischen Prüfmodule geringgehalten. Da lediglich eine Anpassung und Austausch des Aufsatzes erforderlich ist, ist darüber hinaus auch der Zeitaufwand für eine Umrüstung der Prüfmodule gering.

In zweckdienlicher Weiterbildung sind mehrere Typen an Basisteilen ausgebildet, welche sich im Hinblick zumindest auf die Anzahl der Testpunktanschlüsse und vorzugsweise lediglich im Hinblick auf die Anzahl der Testpunktanschlüsse unterscheiden. Speziell weisen die unterschiedlichen Typen n x 8 Testpunktanschlüsse auf mit n=1, 2, 3..., wobei sich die Typen im Faktor n unterscheiden. Durch diese Maßnahme wird der Tatsache Rechnung getragen, dass es einfache Stecker mit nur einer geringen Anzahl von Steckkontakten gibt, beispielsweise zweipolige Stecker und andererseits speziell bei Datenleitungen auch vielpolige Stecker, die beispielsweise mehr als 10 oder mehr als 20 Steckkontakte aufweisen. Bei der Auswahl eines geeigneten Basisteil-Typs wird daher bereits eine Vorauswahl vorgenommen.

Bevorzugt weisen Basisteil und Aufsatz eine Kodierung auf, über die sichergestellt ist, dass nur passende Paare von Basisteil und Aufsatz kombiniert werden. Dies ist insbesondere dann relevant, wenn unterschiedliche Typen an Basisteilen eingesetzt werden. Die Kodierung erfolgt in bevorzugter Ausgestaltung beispielsweise mechanisch und insbesondere über geeignete Rippen, Nuten, Nasen, Bolzen oder sonstige Formelemente, alternativ auch elektrisch, beispielsweise über geeignete Schalter oder Widerstände und insbesondere elektronisch, und hierbei vorzugsweise über ein RFID-Element. Auch ist eine Kodierung mittels eines programmierbaren Speichers möglich. Über eine solche elektronische Kodierung wird eine eindeutige Kodierung erreicht. Speziell wird mithilfe eines RFID-Lesegeräts, welches beispielsweise in dem einen der beiden Teile, insbesondere im Basisteil integriert ist, ein RFID-Tag am anderen Teil, also insbesondere am Aufsatz ausgelesen und überprüft, ob es sich um einen zulässigen Aufsatz handelt. Diese Prüfung erfolgt insbesondere mithilfe der im Basisteil integrierten Steuereinrichtung.

In zweckdienlicher Ausgestaltung ist durch geeignete Maßnahmen eine korrekte, verwechslungssichere Verbindung der elektrischen Anschlüsse zwischen dem Stecker und der Aufnahme sichergestellt ist. Sämtliche elektrischen Verbindungen sind beispielsweise über den verwendeten Steckertyp so gestaltet, dass es jeweils nur einen passenden Aufsatz gibt, in die ein jeweiliger Steckertyp einsetzbar ist. Dies wird insbesondere durch eine mechanische Kodierung, durch einen geeigneten Formfaktor oder eine Markierung erreicht.

In bevorzugter Ausgestaltung weist die Schnittstelle zusätzlich zumindest einen Pneumatikanschluss zum reversiblen Anschluss der zumindest einen Pneumatikleitung auf. Der Pneumatikanschluss ist dabei insbesondere als eine Steckverbindung und/oder Schnellkupplung mit entsprechenden Kupplungsteilen ausgebildet. Die entsprechenden Kupplungsteile sind daher Bestandteile der beiden Schnittstellenteile. Hierdurch lässt sich auch die zumindest eine Pneumatikleitung in einfacher Weise und schnell an eine Druckluftversorgung anschließen.

Eine Steuerung der Druckluft für den Aufsatz erfolgt allgemein über die im Basisteil integrierte Ventileinheit.

Bevorzugt sind mehrere Pneumatikleitungen im Aufsatz angeordnet und integriert, wobei diese für eine Dichtigkeitsprüfung des Steckers und/oder für eine Betätigung der mechanischen Verriegelung vorgesehen sind. Die Verriegelung, insbesondere ein Verriegelungselement wird daher druckluftbetätigt gesteuert und insbesondere entriegelt. Hierzu ist im Aufsatz ein geeignetes pneumatisches Steuerelement integriert.

Bevorzugt ist jeder Pneumatikleitung ein Pneumatikanschluss in der Schnittstelle zugeordnet, insbesondere über die zuvor beschriebene Steckkupplung/Schnellkupplung. Für einen verwechselungssicheren Anschluss ist in zweckdienlicher Ausgestaltung ein jeweiliges Paar (Pneumatikleitung und zugeordneter Pneumatikanschluss) durch eine Kodierung einander zugeordnet. Hierbei kann es sich um eine mechanische Kodierung handeln, sodass also eine falsche Verbindung ausgeschlossen ist. Bevorzugt handelt es sich um eine Farbcodierung, sodass ein jeweiliges Paar die gleiche Farbe aufweist.

Für die Dichtigkeitsprüfung ist vorzugsweise im Aufsatz eine Prüfaufnahme integriert, die zumindest einen Teil des Steckers aufnimmt und die daher innerhalb der Aufnahme für den Stecker angeordnet ist. Diese Prüfaufnahme wird auch als Dichtkäfig bezeichnet. An der Prüferaufnahme ist zumindest eine der Pneumatikleitungen angeschlossen. Im Betrieb und für die Dichtigkeitsprüfung wird die Prüfaufnahme mit Druckluft beaufschlagt und es wird überprüft, ob Druckluft über ein unerwünschtes Leck entweicht. Für diese Dichtigkeitsprüfung weist der Aufsatz insbesondere zwei Pneumatikleitungen auf, eine Hinleitung und eine Rückleitung, wobei letztere insbesondere zu einem im Basisteil angeordneten Lecksensor geführt ist. Bei einer Undichtigkeit strömt über die Rückleitung Luft, die von dem Lecksensor detektiert wird. Allgemein ist in bevorzugter Ausgestaltung daher im Basisteil der Lecksensor als Teil der Sensorik integriert, welcher mit der zumindest einen Pneumatikleitung zur Erfassung einer eventuellen Undichtigkeit des Steckers verbunden ist.

Bevorzugt weist der Aufsatz weiterhin eine mechanische und insbesondere steuerbare Verriegelung für den Stecker auf, sowie ein insbesondere als Schalter ausgebildetes Kontrollelement zur Prüfung, ob die Aufnahme mit einem Stecker belegt ist.

Zweckdienlicherweise weist das Basisteil eine Sensorik zur Erfassung und Auswertung von steckerrelevanten Zuständen auf, wie z.B. Anwesenheit eines Steckers und / oder Farbe des Steckers, wobei die Sensorik beispielsweise zur Erfassung und Auswertung eines momentanen (Schalt-) Zustands des Kontrollelements ausgebildet ist, um aus diesem abzuleiten, ob ein Stecker in die Aufnahme eingesteckt ist

In bevorzugter Weiterbildung weist der Aufsatz weiterhin zumindest eine optische Leitung auf, die also zur Weiterleitung eines Lichtsignals und beispielsweise als eine optische Faser ausgebildet ist, wobei diese mit einem optischen Sensor als Teil der Sensorik im Basisteil verbunden ist. Dieser optische Sensor und die optische Leitung dienen insbesondere zur Feststellung der Farbe des in der Aufnahme eingesetzten Steckers. Anhand der Farbe sind Stecker häufig kodiert, sodass über die Farbe überprüft werden kann, welcher Steckertyp eingesetzt ist und ob dies der richtige ist.

Die Schnittstelle weist in bevorzugter Ausgestaltung ergänzend auch einen optischen Anschluss zum reversiblen Anschluss der zumindest einen optischen Leitung auf. Auch hier ist bevorzugt wieder ein Steckanschluss und/oder eine Schnellkupplung ausgebildet mit entsprechenden Kupplungsteilen in den beiden Schnittstellenteilen im Basisteil einerseits und am Aufsatz andererseits.

Die Schnittstelle weist daher insgesamt in bevorzugter Ausgestaltung für sämtliche Verbindungsleitungen und Versorgungsleitungen, die zum Aufsatz führen, also insbesondere für sämtliche elektrische Verbindungsleitungen, für sämtliche optische Leitungen und für sämtliche Pneumatikleitungen oder auch für eventuelle weitere Leitungen jeweils Anschlüsse auf, sodass die Verbindungen zu den aufsatzseitigen Leitungen jeweils reversibel getrennt werden können. Eine derartige Schnittstelle wird auch als Komfort-Schnittstelle bezeichnet, da über diese sämtliche Leitungen montagefreundlich anschließbar sind. Ein entsprechend ausgestaltetes modulares Komfort-Prüfmodul ist insbesondere für Anwendungsfälle vorgesehen, bei denen häufig ein Austausch des steckerspezifischen Aufsatzes erfolgt. Diese Komfort-Schnittstelle ist beispielsweise für Anwendungsfälle vorgesehen, bei denen pro Tag etwa 1 bis 10 Wechsel des Aufsatzes stattfinden. Diese Komfort-Variante ist insbesondere bei Kabelsätzen mit nur geringer Stückzahl und daher mit entsprechend häufigen Wechsel von Vorteil. Durch die sehr einfache Anpassung und dem einfachen und zeitsparenden Wechsel ergibt sich hierbei insbesondere auch der Vorteil, dass die Anzahl der Prüfvorrichtung, also die Anzahl der sogenannten Prüftische geringgehalten werden kann, da diese zügig umgebaut werden können und auch für mehrere Kabelsätze verwendet werden können.

Alternativ hierzu ist eine einfache Schnittstelle ausgebildet, bei der nur ein Teil der Versorgungsleitungen, nämlich zumindest die elektrischen Verbindungsleitungen über die lösbare elektrische Steckverbindung geführt sind. Die weiteren Leitungen, beispielsweise die zumindest eine Pneumatikleitung und/oder die zumindest eine optische Leitung, sind demgegenüber unmittelbar und unterbrechungsfrei vom Aufsatz in das Basisteil hinein zu entsprechenden Komponenten wie beispielsweise der Ventileinheit oder dem optischer Sensor geführt. Eine derartige einfache Schnittstelle ist für Anwendungsfälle vorgesehen, bei denen nur eine geringe Wechselrate von beispielsweise 1 bis 10 Wechsel des Aufsatzes pro Nutzungszeitraum zu erwarten ist, wobei der Nutzungszeitraum üblicherweise zumindest mehrere Wochen oder auch mehrere Monate beträgt.

Speziell für die zuvor beschriebene Komfort-Schnittstelle weist das basisseitige und/oder das aufsatzseitige Schnittstellenteil vorzugsweise einen gemeinsamen Träger auf, in dem das Kupplungsteil für den elektrischen Steckverbinder einerseits sowie andererseits der zumindest eine pneumatische Anschluss und/oder der zumindest eine optischen Anschluss gemeinsam angeordnet sind. Bei den Kupplungsteilen handelt es sich daher beim elektrischen Steckverbinder um ein männliches oder weibliches Steckverbinderteil, und bei dem Pneumatikanschluss sowie beim optischen Anschluss jeweils um ein geeignetes pneumatisches bzw. optisches Kupplungsteil. Bevorzugt sind sämtliche Kupplungsteile als Steckkupplungen oder zumindest als lösbare Schnellkupplungen ausgebildet. Speziell bei der Ausgestaltung als Steckkupplungen braucht der Aufsatz insgesamt lediglich auf das Basisteil aufgesteckt zu werden, wobei durch das Aufstecken vorzugsweise sämtliche Kupplungsteile automatisch miteinander verbunden werden.

Alternativ hierzu besteht auch die Möglichkeit, dass die Kupplungsteile in den Träger beispielsweise lose gehalten sind und dass sie manuell und einzelweise mit den jeweils anderen Kupplungsteilen verbunden werden. Beispielsweise sind zumindest einige der Kupplungsteile, beispielsweise für den pneumatische Anschluss und/oder für den optischen Anschluss, lose im Träger gehalten und können vorzugsweise ein Stück weit aus diesem herausgeführt werden, um die Verbindung und die Montage zu vereinfachen.

Die einzelnen Verbindungs- und Versorgungsleitungen (elektrisch, optisch, pneumatisch) sind vorzugsweise im Aufsatz von dem aufsatzseitigen Schnittstellenteil in Richtung zu der Aufnahme geführt und beispielsweise durch einen Boden der Aufnahme hindurchgeführt. Sie sind hierbei insbesondere als lose Einzelleitungen geführt, sodass insbesondere ein gewisser Längenausgleich ermöglicht ist.

Auf Seite des Basisteils sind in bevorzugter Ausgestaltung ebenfalls Einzelleitungen (elektrisch, optisch, pneumatisch) von dem basisseitigen Schnittstellenteil zu den jeweiligen korrespondierenden Komponenten wie Sensorik, Ventileinheit, Steuereinheit usw. geführt.

In zweckdienlicher Ausgestaltung weist das Basisteil eine Basisaufnahme auf, in die der Aufsatz im montierten Zustand eingesetzt und insbesondere eingesteckt ist. Der Aufsatz selbst wird daher innerhalb dieser Basisaufnahme angeordnet und ist in dieser gehalten und geführt. In bevorzugter Ausgestaltung ist in einem Boden der Basisaufnahme das basisseitige Schnittstellenteil angeordnet und fixiert und der Aufsatz weist an seiner Unterseite das aufsatzseitige Schnittstellenteil auf.

Bevorzugt ist der Aufsatz im Basisteil durch eine lösbare, insbesondere mechanische Arretierung fixiert, wodurch insbesondere auch eine Zugentlastung für die Schnittstelle erhalten ist.

In zweckdienlicher Ausgestaltung ist das Basisteil zur Aufnahme von unterschiedlich ausgebildeten Aufsätzen ausgebildet, wobei für die verschiedenen Aufsätze ein identisches basisseitiges Schnittstellenteil ausgebildet ist. Das Basisteil bildet daher ein universelles Basisteil für eine Vielzahl von verschiedenen Aufsätzen.

Das erfindungsgemäße Prüfmodul-Set weist daher bevorzugt zumindest ein gemeinsames Basisteil auf, in welches jeweils unterschiedliche Aufsätze eingesteckt werden können. Das gemeinsame Basisteil bildet also das zuvor erwähnte universelle Basisteil für eine Vielzahl der unterschiedlichen Aufsätze aus. Das Set kann dabei ein einziges oder auch mehrere gemeinsame Basisteile aufweisen. Das gemeinsame Basisteil bildet daher einen definierten Basisteil-Typ aus, welcher also mit unterschiedlichen Aufsätzen kombiniert werden kann.

Bevorzugt weist das Prüfmodul-Set verschiedene Typen an Basisteilen auf und vorzugsweise ergänzend unterschiedliche Typen an Aufsätzen, wobei die unterschiedlichen Typen an Aufsätzen an die unterschiedlichen Typen an Basisteilen angepasst sind, beispielsweise im Hinblick auf einen Formfaktor (zueinander passende Geometrie). Zu einem jeweiligen Aufsatz-Typ enthält das Set vorzugsweise mehrere unterschiedlich ausgebildete Aufsätze, die sich insbesondere im Hinblick auf die steckerspezifischen Aufnahmen unterscheiden.

Ein jeweiliger Basisteil-Typ ist für unterschiedliche Steckertypen und damit auch für verschiedene Aufsätze ausgebildet, wobei auch hier jeweils wieder für die verschiedenen Aufsätze ein identisches basisseitiges Schnittstellenteil pro Basisteil-Typ ausgebildet ist. Dies bedeutet, dass ein jeweiliger Typ immer das gleiche basisseitige Schnittstellenteil aufweist.

Ein jedes der Prüfmodule ist in bevorzugter Ausgestaltung mit einer zentralen Versorgungseinrichtung der Prüfvorrichtung über zumindest eine Kommunikationsverbindung sowie ergänzend pneumatisch zur Druckluftversorgung verbunden. Die zentrale Versorgungseinrichtung weist hierzu insbesondere eine zentrale Recheneinheit und ergänzend eine Druckluftversorgung auf. Diese beiden Elemente sind beispielsweise, jedoch nicht notwendigerweise innerhalb einer gemeinsamen Baueinheit integriert. Über die Kommunikationsverbindung erfolgt ein Datenaustausch, sodass beispielsweise ein Prüffortschritt überwacht werden kann. Über die zentrale Druckluftversorgung werden die einzelnen Prüfmodule mit Druckluft versorgt.

Gemäß einer ersten Ausführungsvariante sind die Testpunktanschlüsse des Prüfmoduls ebenfalls mit der zentralen Versorgungseinrichtung verbunden, insbesondere drahtgebunden, und zwar bevorzugt über jeweils eine Einzeldraht-Verbindung zwischen einem jeden Testpunktanschluss und der zentralen Versorgungseinrichtung. Dies erfolgt über Prüfleitungen. Bei dieser Ausführungsvariante wird die Steuerung der Prüfung des Kabelsatzes und damit der einzelnen Prüfschritte für die Prüfung von der zentralen Versorgungseinrichtung ausgeführt. Hierzu werden über die Prüfleitungen von der zentralen Versorgungseinrichtung Prüfsignale in einer vorbestimmten Art und Weise abgegeben und auch ausgewertet.

Alternativ hierzu sind die Prüfmodule bevorzugt als sogenannte intelligente Prüfmodule ausgebildet, bei der eine beispielsweise mittels Software aufspielbare Prüflogik hinterlegt ist, anhand derer die für die Prüfung erforderlichen Prüfschritte veranlasst werden. Über diese integrierte Prüfintelligenz werden daher die erforderlichen Prüfsignale erzeugt und an die einzelnen Testpunktanschlüsse angelegt. Bei einem solchen intelligenten Modul ist bevorzugt zu der zentralen Versorgungseinrichtung lediglich eine Kommunikationsverbindung sowie gegebenenfalls eine Stromversorgungsleitung ausgebildet, ohne dass Prüfleitungen erforderlich sind. Hierdurch sind der Verdrahtungsaufwand und damit auch Gewicht und Komplexität vereinfacht.

Die entsprechende Prüfintelligenz ist insbesondere innerhalb des Basisteils 22 integriert. Diese Prüfintelligenz wird üblicherweise durch eine geeignete Steuer- und Auswerteeinheit gebildet, welche insbesondere Teil der Steuereinheit des Basisteils ist. Insbesondere wird die Prüfintelligenz durch eine sogenannte Testpunktkarte bereitgestellt. Bei dieser handelt es sich insbesondere um eine Leiterplatte mit geeigneten darauf angebrachten elektronischen Bauteilen, typischerweise inklusive eines Prozessors, über die die einzelnen Prüfschritte gesteuert und ausgewertet werden. Diese Karte ist beispielsweise in einem geeigneten Steckplatz innerhalb des Prüfmoduls speziell innerhalb des Basisteils und zwar insbesondere in einen Steckplatz der Steuereinheit eingesteckt. Für unterschiedliche Prüfaufgaben können dabei unterschiedliche Karten eingesteckt werden. Bei einer Ausgestaltung ohne derartige intelligente Prüfmodule sind derartige Karten typischerweise in der zentralen Versorgungseinrichtung, insbesondere in der erwähnten zentralen Recheneinheit integriert.

Die Kommunikationsverbindung mit der zentralen Versorgungseinrichtung erfolgt vorzugsweise drahtgebunden. Für die Kommunikation wird allgemein ein geeigneter Datenbus eingesetzt, wie Ethernet, LIN... , (LAN, WLAN). Ein Datenbus bietet im Vergleich zu einer 1:1 Verkabelung zwischen Testmodul und einem zentralen Tester den Vorteil, dass das System aufgrund geringerer Komplexität und geringen Gewichts besonders gut für einen Einsatz in einer Montagelinie geeignet ist.

Die Prüfvorrichtung ist bevorzugt innerhalb einer Montagelinie für die Kabelsatzfertigung integriert. Hierunter wird verstanden, dass die Prüfung direkt während der Kabelsatzfertigung insbesondere auch an teilgefertigten Kabelsätzen erfolgt, sodass Fehler frühzeitig erkannt und behoben werden können. Es ist also in bevorzugter Ausgestaltung gerade keine "end of line" - Prüfung vorgesehen, bei der eine Prüfung erst nach kompletter Herstellung des Kabelsatzes erfolgt.

Alternativ ist auch ein Einsatz bei einem klassischen stationären Prüftisch denkbar und das hier beschriebene Prüfsystem wird bevorzugt auch an einem solchen stationären Prüftisch eingesetzt.

Ausführungsbeispiele der Erfindung werden nachfolgend anhand der Figuren näher erläutert. Diese zeigen in vereinfachten Darstellungen:
- FIG 1: eine Aufsicht auf eine Prüfvorrichtung mit darauf angebrachtem Kabelsatz,
- FIG 2: eine perspektivische, ausschnittsweise Ansicht einer Prüfvorrichtung mit einem Prüfmodul
- FIG 3: eine schematisierte Darstellung eines modularen Prüfmoduls in Komfort-Ausstattung mit einer Komfort-Schnittstelle sowie
- FIG 4: eine schematisierte Darstellung eines modularen Prüfmoduls ein einer einfachen Ausgestaltung mit einer Einfach-Schnittstelle.

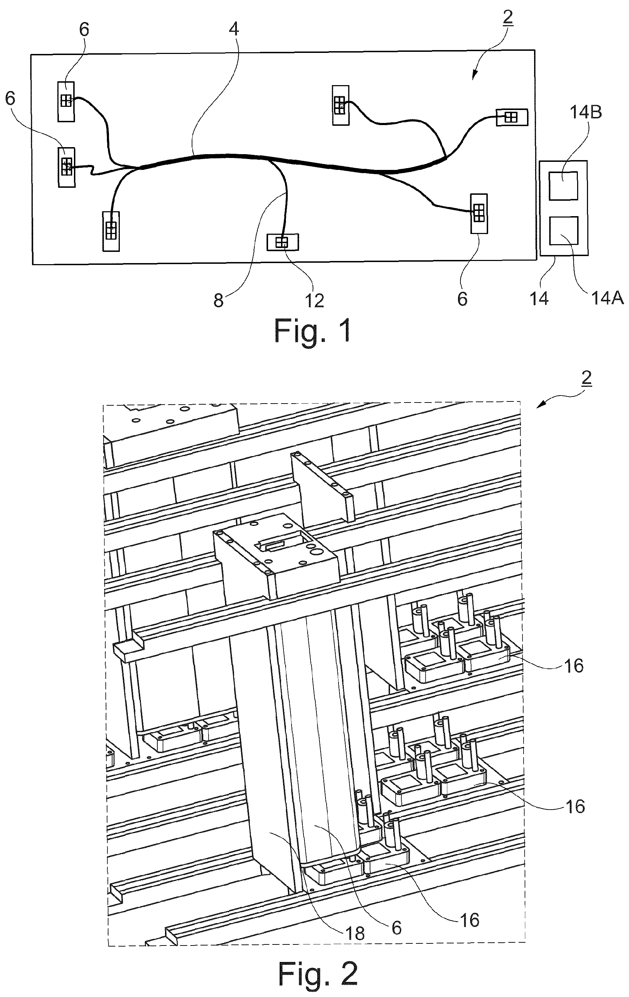

FIG 1 zeigt eine schematisierte Aufsicht auf eine als Prüftisch ausgebildete Prüfvorrichtung 2 für die Funktionsprüfung eines darauf temporär für die Prüfung angebrachten Kabelsatzes 4. Speziell handelt es sich bei dem Kabelsatz 4 um einen Kabelsatz 4, welcher in der montierten Endstellung in einem Kraftfahrzeug angebracht ist. Die Prüfvorrichtung 2 ist üblicherweise modular aufgebaut und weist eine Vielzahl von einzelnen Prüfmodulen 6 auf, die an der Prüfvorrichtung 2 weitgehend frei, beispielsweise entlang eines vorgegebenen Rastermaßes positionierbar sind. Hierzu sind typischerweise am Prüftisch 2 entsprechende Raster- oder Steckplätze für ein jeweiliges Prüfmodul 6 vorgesehen, die auch als Modulplätze bezeichnet werden.

Der Kabelsatz 4 weist üblicherweise eine verzweigte Struktur auf mit mehreren abzweigenden Kabelsträngen 8, die üblicherweise selbst wiederum mehrere einzelne elektrische Leitungen aufweisen, die typischerweise endseitig an einem jeweiligen Stecker 12 angeschlossen sind. Im Ausführungsbeispiel ist an einem jeweiligen Prüfmodul 6 jeweils genau ein Kabelstrang 8 mittels eines Steckers 12 angeschlossen.

Für die Prüfung des Kabelsatzes 4 wird jede einzelne Leitung individuell im Hinblick auf ihre Durchlässigkeit geprüft, wobei hierzu typischerweise eine Widerstandsmessung mit Hilfe von angelegten Prüfsignalen durchgeführt wird.

Der Prüftisch 2 weist häufig eine interne Verdrahtung auf, über die die einzelnen Steckplätze für die Prüfmodule 6 und damit auch die Prüfmodule 6 geeignet angeschlossen und beispielsweise mit einer zentralen Versorgungseinrichtung 14 verbunden sind. Diese weist im Ausführungsbeispiel eine zentrale Auswerte- oder Recheneinheit 14A sowie eine zentrale Druckluftversorgung 14B auf. Mit der Recheneinheit 14A sind die einzelnen Prüfmodule 6 zumindest zur Ausbildung einer Kommunikationsverbindung verdrahtet.

Die Prüfmodule 6 erhalten von der zentralen Versorgungseinrichtung drahtgebunden Prüfsignale, die über die Prüfmodule 6 entsprechend eines vorgegebenen Prüfablaufs in die einzelnen Leitungen des Kabelsatzes 4 eingespeist werden. Alternativ sind die Prüfmodule 6 als intelligente Prüfmodule 6 ausgebildet, die die Prüfsignale selbst erzeugen und auswerten.

FIG 2 zeigt eine ausschnittsweise perspektivische Ansicht auf die Prüfvorrichtung 2, wobei eine obere Tischplatte sowie auch sonstige seitliche Verkleidungsteile nicht dargestellt sind. Zu erkennen ist, dass die Prüfvorrichtung 2 ein Gestell aufweist, an dem ein jeweiliges Prüfmodul 6 beispielsweise befestigt ist. Die Prüfvorrichtung 2 weist mehrere Modulplätze 16 auf, die jeweils mit einem Prüfmodul 6 verbunden werden können. Bevorzugt erfolgt die Verbindung dabei durch ein einfaches Aufstecken des Prüfmoduls 6 über geeignete Steckverbinder. Über den jeweiligen Modulplatz 16 wird jeweils die erforderliche Versorgung und Anbindung eines jeweiligen Prüfmoduls 6 an die zentrale Versorgungseinrichtung 14 bereitgestellt. Über den Modulplatz 16 werden insbesondere Kommunikationsleitungen, gegebenenfalls Prüfleitungen sowie insbesondere auch eine Druckluftversorgung über entsprechende Druckluft-Anschlüsse (Steck-Anschlüsse) zur Verfügung gestellt.

Im Ausführungsbeispiel ist einem jeweiligen Modulplatz 16 eine vertikal orientierte Montageplatte 18 zugeordnet, an der sich das jeweilige Prüfmodul 6 mit einer Randseite anlehnt. Das Prüfmodul 6 weist allgemein ein Gehäuse auf.

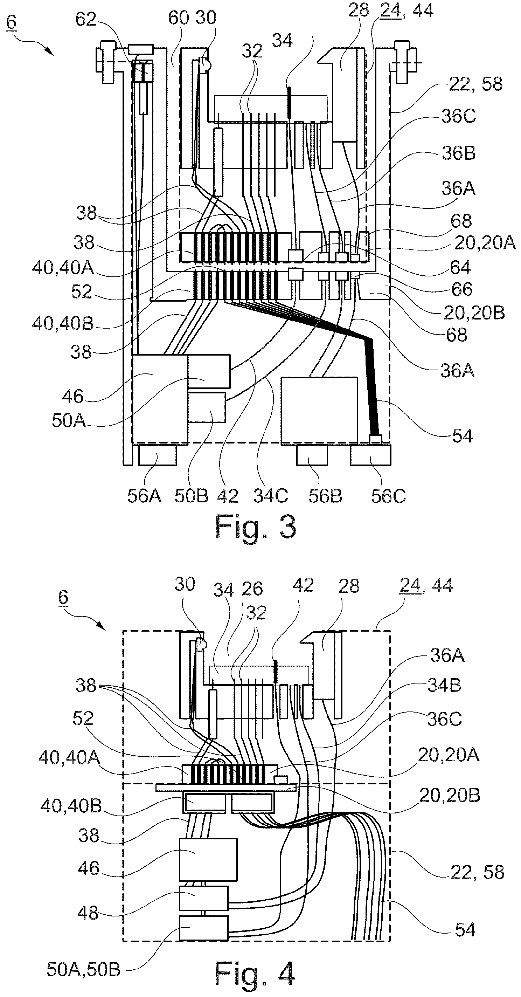

Das Prüfmodul 6 ist modular aufgebaut wie dies nachfolgend im Zusammenhang mit FIG 3 sowie FIG 4 näher erläutert wird. FIG 3 zeigt dabei eine Komfort-Variante mit einer als Komfort-Schnittstelle ausgebildeten Schnittstelle 20, wohingegen FIG 4 eine einfache Variante mit lediglich einer als einfache Schnittstelle ausgebildeten Schnittstelle 20 zeigt.

In beiden Fällen weist das Prüfmodul 6 ein Basisteil 22 sowie einen daran angebrachten steckerspezifischen Aufsatz 24 mit folgenden Merkmalen auf:
Der Aufsatz 24 weist eine steckerspezifische Aufnahme 26 auf, deren Form insbesondere an die Form eines aufzunehmenden Steckers 12 angepasst ist. Über die Formanpassung ist daher quasi eine Kodierung erreicht, sodass nur ein spezifischer Steckertyp in die Aufnahme 26 eingesetzt werden kann.

Der Aufsatz 24 weist eine mechanische Verriegelung 28 für den jeweiligen Stecker 12 auf. Diese weist als formschlüssiges Verriegelungselement beispielsweise einen hakenförmigen und verschieblich gelagerten Zylinder auf, welcher über Druckluft steuerbar ist.

Weiterhin weist der Aufsatz 24 ein als elektrischer Schalter ausgebildetes Kontrollelement 30 auf, welches zur Prüfung dient, ob in die Aufnahme 26 ein Stecker 12 eingesetzt ist.

Im Boden der Aufnahme 26 sind eine Vielzahl von Prüfkontakten 32 angebracht, die insbesondere als Prüfstifte ausgebildet sind. Diese dringen in entsprechende Kontaktaufnahmen des Steckers 12 ein und dienen zum Einspeisen der Prüfsignale in die am Stecker 12 angeschlossenen Leitungen.

In der Aufnahme 26 ist weiterhin eine Prüfaufnahme 34 zur Durchführung einer Dichtigkeitsprüfung angeordnet. Der Prüfaufnahme 34 wird auch als Dichtkäfig bezeichnet.

Im Aufsatz 24 sind mehrere Pneumatikleitungen 36A-36C integriert, wobei die eine mit der mechanischen Verriegelung und die beiden anderen mit der Prüfaufnahme 34 verbunden sind.

Die einzelnen Prüfkontakte 32 sind über elektrische Verbindungsleitungen 38 mit einem Steckerteil 40A eines Steckverbinders 40 verbunden. Weitere Verbindungsleitungen 38 führen von dem Kontrollelement 30 zum Steckerteil 40A.

Weiterhin ist noch eine optische Leitung 42 integriert, welche sich bis in die Aufnahme 26 hinein erstreckt und endseitig insbesondere ein beispielsweise als optische Linse ausgebildetes optisches Element zum Eintritt und Austritt eines optischen Prüfsignals aufweist.

Der Aufsatz 24 weist beispielsweise ein Aufsatz-Gehäuse 44 auf, welches in den Figuren gestrichelt dargestellt ist.

Auf Seiten des Aufsatzes 24 weist die Schnittstelle 20 ein aufsatzseitiges Schnittstellenteil 20A auf, welches zumindest das Steckerteil 40A des elektrischen Steckverbinders 40 aufweist.

Im Basisteil 22 ist in beiden Ausführungsvarianten eine Steuereinheit 46 sowie eine Ventileinheit 48 angeordnet, die im Ausführungsbeispiel mehrere Ventile für zumindest zwei Pneumatikleitungen 36A, B aufweist, um über die Ventile diese Pneumatikleitungen 36A, B in geeigneter Weise mit Druckluft zu beaufschlagen. Weiterhin ist im Basisteil 22 eine Sensorik verbaut, in der insbesondere mehrere Sensoren integriert sind, nämlich ein optischer Sensor 50A zur Auswertung des optischen Prüfsignals, welches über die optische Leitung 42 bereitgestellt wird sowie weiterhin einen Lecksensor 50B, welcher an der dritten Pneumatikleitung 34C angeschlossen ist. Die beiden Sensoren 50A, B sind lediglich in der FIG 3 als getrennte Baueinheiten dargestellt.

Im Basisteil 22 sind weiterhin eine Vielzahl von Testpunktanschlüssen 52 bereitgestellt, und zwar insbesondere an der Schnittstelle 20 und dort insbesondere durch das basisseitige Steckerteil 40B des Steckverbinders 40. An diesen Testpunktanschlüssen 52 sind Prüfleitungen 54 angeschlossen, welche im Ausführungsbeispiel drahtgebunden zu der zentralen Versorgungseinrichtungen 14 geführt sind.

Das Basisteil 22 weist weiterhin mehrere Modul-Schnittstellen 56A-C auf (nur zu

FIG 3 dargestellt), die zur Verbindung, speziell zur Steckverbindung mit dem jeweiligen Modulplatz 16 ausgebildet sind. Über diese Modul-Schnittstellen 56A-C ist im Ausführungsbeispiel ein Kommunikationsanschluss (verbunden mit der Steuereinheit 46), ein Druckluft-Anschluss (verbunden mit der Ventileinheit 48) sowie eine Prüfanschluss bereitgestellt, an den die Prüfleitungen 54 angeschlossen sind.

Das Basisteil 22 weist beispielsweise ein Basis-Gehäuse 58 auf, welches gestrichelt dargestellt ist.

Die Schnittstelle 20 ist auf Seiten des Basisteils 20 durch ein basisseitiges Schnittstellenteil 20B gebildet, welches zumindest das basisseitige Steckerteil 40B aufweist. Die Steckerteile 40A, B können jeweils selbst mehrere Steckerteile aufweisen, wie dies beispielsweise in der FIG 4 beim basisseitigen Steckerteil 40B dargestellt ist.

Die zuvor beschriebenen Leitungen, nämlich die Verbindungsleitungen 38 sowie die Pneumatikleitungen 36A-C und die optische Leitung 42 sind im Basisteil 22 weitergeführt und zwar zu den entsprechenden im Basisteil 22 angeordneten Komponenten.

Nachfolgend wird auf die Unterschiede zwischen den beiden Varianten gemäß FIG 3 und FIG 4 eingegangen:
Bei der Komfort-Variante gemäß FIG 3 weist das Basisteil 22 eine Basisaufnahme 60 auf, die beispielsweise in etwa topfförmig ausgebildet ist und in der der Aufsatz 24 wie er zuvor beschrieben wurde, eingesetzt ist.

Die Basisaufnahme 60 bildet insofern ein Teil des Basis-Gehäuses 58 aus. Dieses weist im Ausführungsbeispiel der FIG 3 einen oberen Kragen auf, durch den Befestigungselemente, insbesondere Schrauben zur Befestigung an dem Gestell der Prüfvorrichtung 2 geführt sind.

In FIG 3 ist weiterhin die zuvor beschriebene seitliche Montageplatte 18 des Modulplatzes 16 zu erkennen, an die sich das Prüfmodul 6 mit einer ihrer Seitenwände anlehnt.

Zur Sicherstellung, dass das Basisteil 22 nur mit einem zulässigen Aufsatz 24 kombiniert wird, ist im Ausführungsbeispiel der FIG 3 eine Kodierung vorgesehen, die durch eine elektronische Kodierung ausgebildet ist. Und zwar ist eine Kodierung über ein RFID-Element 62 ausgebildet. In FIG 3 ist am Basisteil 22 beispielsweise ein Lesegerät als RFID-Element 62 angeordnet, welches mit einem zugeordneten, hier nicht näher dargestellten RFID-Tag am Aufsatz 24 kommuniziert und dessen Daten in an sich bekannter Weise ausliest. Das RFID-Element 62 ist mit der Steuereinheit 46 verbunden, die das Signal entsprechend auswertet und prüft, ob ein zulässiger Aufsatz 24 eingesetzt ist.

Bevorzugt verfügen die RFID-Tags insbesondere ergänzend oder alternativ über eine elektrische Schnittstelle für eine direkte Kommunikation, so dass eine Antenne nicht bzw. nicht zwingend benötigt wird. Bei einer kombinierten Variante ist daher sowohl eine drahtgebundene als auch eine drahtlose Kommunikation ermöglicht.

Weiterhin ist von besonderer Bedeutung, dass die beiden Schnittstellenteile 20A, B jeweils Kupplungsteile für sämtliche Leitungen aufweist, also im Ausführungsbeispiel für die Verbindungsleitungen 38/Prüfleitungen 54, für die optische Leitung 42 sowie für die Pneumatikleitungen 36A-C. Bei den Kupplungsteilen handelt es sich dabei um die bereits beschriebenen Steckerteile 40A, B des elektrischen Steckverbinders 40, um optische Kopplungsteile eines optischen Anschlusses 64 sowie für jede Pneumatikleitung 36A-C um jeweils ein Paar an Kupplungsteilen von Pneumatikanschlüssen 66.

Diese Kupplungsteile sind dabei jeweils in einem gemeinsamen Träger 68 integriert. Die Kupplungsteile sind beispielsweise jeweils als Steckkupplungsteile ausgebildet.

Das Basisteil 22 wird insbesondere in unterschiedlichen Typen bereitgestellt, die sich vorzugsweise im Hinblick auf die Anzahl der Testpunktanschlüsse 52 unterscheiden. Beispielsweise werden Basisteile 22 mit 1n, 2n, 3n..... Testpunktanschlüssen 52 bereitgestellt, wobei n eine Zahl ist, beispielsweise 4 und insbesondere 8.

Je nach zu prüfendem Stecker 12 ist die Aufnahme 26 unterschiedlich ausgestaltet und insbesondere unterscheiden sich die unterschiedlichen Aufsätze 24 auch in der Anzahl und der Positionierung der Prüfkontakte 32.

Über die Schnittstelle 20 wird zumindest für jeden Typ an Basisteil 22 ein identisches basisseitiges Schnittstellenteil 22 B bereitgestellt. Bevorzugt ist die Schnittstelle, also beide Schnittstellenteile 20A, 22B jeweils identisch, die Anpassung an unterschiedliche Stecker 12 erfolgt dann beispielsweise durch die interne Verdrahtung im Aufsatz 24. Beispielsweise sind lediglich einige der Testpunktanschlüsse 52 mit den Prüfkontakten 32 verbunden und andere sind unbelegt oder auch überbrückt, wie dies in FIG 3 und FIG 4 skizziert ist.

### Bezugszeichenliste

- 2: Prüfvorrichtung
- 4: Kabelsatz
- 6: Prüfmodul
- 8: Kabelstrang
- 12: Stecker
- 14: zentrale Versorgungseinrichtung
- 14A: zentrale Recheneinheit
- 14B: Druckluftversorgung
- 16: Modulplatz
- 18: Montageplatte
- 20: Schnittstelle
- 20A: aufsatzseitige Schnittstellenteil
- 20B: basisseitiges Schnittstellenteil
- 22: Basisteil
- 24: Aufsatz
- 26: Aufnahme
- 28: mechanische Verriegelung
- 30: Kontrollelement
- 32: Prüfkontakt
- 34: Prüfaufnahme für Dichtigkeitsprüfung
- 36A-C: Pneumatikleitungen
- 38: Verbindungsleitungen
- 40: Steckverbinder
- 40A, B: Steckerteile
- 42: optische Leitung
- 44: Aufsatz-Gehäuse
- 46: Steuereinheit
- 48: Ventileinheit
- 50A: optischer Sensor
- 50B: Lecksensor
- 52: Testpunktanschlüssen
- 54: Prüfleitungen
- 56A-C: Modul-Schnittstelle
- 58: Basis-Gehäuse
- 60: Basisaufnahme
- 62: RFID-Element
- 64: optischer Anschluss
- 66: Pneumatikanschluss
- 68: Träger

## Patentansprüche

1. Prüfsystem zur Prüfung von Kabelsätzen (4) mit einer Prüfvorrichtung (2), in die mehrere Prüfmodule (6) einsetzbar sind, wobei an jedes Prüfmodul (6) ein Stecker (12) des zu prüfenden Kabelsatzes (4) einsteckbar ist, wobei die Prüfmodule (6) modular aufgebaut sind mit einem Basisteil (22) und einem daran über eine Schnittstelle (20) austauschbar befestigten steckerspezifischen Aufsatz (24), wobei
- der Aufsatz (24) aufweist eine steckerspezifische Aufnahme (26), in die der Stecker (12) einsteckbar ist sowie eine Vielzahl von Prüfkontakten (32) zur elektrischen Prüfung von Leitungen des Kabelsatzes (4),
- das Basisteil (22) aufweist eine Mehrzahl von Testpunktanschlüssen (52), über die für die Prüfung jeweils einer Leitung Prüfsignale bereitgestellt werden sowie eine Steuereinheit (46),
- der Aufsatz (24) und das Basisteil (22) über elektrische Verbindungsleitungen (38) miteinander verbunden sind und wobei
- die Schnittstelle (20) ein basisseitiges Schnittstellenteil (20B) sowie ein aufsatzseitiges Schnittstellenteil (20A) aufweist, über die ein lösbarer elektrischer Steckverbinder (40) für insbesondere sämtliche elektrische Verbindungsleitungen (38) zwischen dem Aufsatz (24) und dem Basisteil (22) bereitgestellt ist.

2. Prüfsystem nach dem vorhergehenden Anspruch, wobei mehrere Typen an Basisteilen (22) vorgesehen sind, welche sich im Hinblick auf die Anzahl der Testpunktanschlüsse (52) unterscheiden, wobei jeder Typ vorzugsweise zur Aufnahme (26) von unterschiedlich ausgebildeten Aufsätzen (52) ausgebildet ist, wobei für die verschiedenen Aufsätze (24) zumindest für jeden Typ ein identisches basisseitiges Schnittstellenteil (20B) ausgebildet ist.

3. Prüfsystem nach dem vorhergehenden Anspruch, wobei Basisteil (22) und Aufsatz (24) eine Kodierung aufweisen, über die sichergestellt ist, dass nur passende Paare von Basisteil (22) und Aufsatz (24) kombiniert werden, wobei die Kodierung vorzugsweise mechanisch, elektrisch oder elektronisch, insbesondere über ein RFID-Element (62) erfolgt.

4. Prüfsystem nach einem der vorhergehenden Ansprüche, bei dem der Aufsatz (24) zumindest eine Pneumatikleitung (36A-36C) aufweist und das Basisteil (22) eine Ventileinheit (48) mit zumindest einem pneumatischen Ventil zur Versorgung der Pneumatikleitung (36A- 36C) im Aufsatz (24) aufweist, wobei in bevorzugten Weiterbildungen
- die Schnittstelle (20) zusätzlich zumindest einen Pneumatikanschluss (66) zum reversiblen Anschluss der zumindest einen Pneumatikleitung (36A-36C) im Aufsatz (24) aufweist, und / oder
- mehrere Pneumatikleitungen (36A-36C) im Aufsatz (24) integriert sind, wobei diese für eine Dichtigkeitsprüfung und/oder eine Betätigung der mechanischen Verriegelung (28) vorgesehen sind...

5. Prüfsystem nach dem vorhergehenden Anspruch, bei dem den Pneumatikleitungen (36A-36C) jeweils ein Pneumatikanschluss (66) zugeordnet ist und eine jede Pneumatikleitung (36A-36C) durch eine Kodierung, insbesondere Farbkodierung dem zugeordneten Pneumatikanschluss (66) verwechslungssicher zugeordnet ist.

6. Prüfsystem nach einem der beiden vorhergehenden Ansprüche , wobei der Aufsatz (24) eine Prüfaufnahme (34) für eine Dichtigkeitsprüfung des Steckers (12) aufweist und die Prüfaufnahme (34) an die zumindest eine Pneumatikleitung (36B, 36C) angeschlossen ist.

7. Prüfsystem nach dem vorhergehenden Anspruch, wobei die Sensorik im Basisteil (22) einen Lecksensor (50B) zur Erfassung einer eventuellen Undichtigkeit des Steckers (12) aufweist, wobei der Lecksensor (50B) mit einer der Pneumatikleitungen (36C) verbunden ist.

8. Prüfsystem nach einem der vorhergehenden Ansprüche, wobei das Basisteil (22) eine Sensorik (50A, 50B) zur Erfassung von steckerrelevanten Zuständen eines in der Aufnahme (26) aufgenommenen Steckers (12) aufweist.

9. Prüfsystem nach einem der vorhergehenden Ansprüche, wobei der Aufsatz (24) weiterhin zumindest eine optische Leitung (42) aufweist, die mit einem optischen Sensor (50A) als Teil der Sensorik verbunden ist, wobei die Schnittstelle (20) vorzugsweise zusätzlich einen optischen Anschluss (64) zum reversiblen Anschluss der zumindest einen optischen Leitung (42) aufweist .

10. Prüfsystem nach einem der vorhergehenden Ansprüche , wobei der basisseitige und/oder der aufsatzseitige Schnittstellenteil (20A, 20B) einen Träger (68) aufweist, in dem jeweils ein Kupplungsteil für den elektrischen Steckverbinder (40), für den zumindest einen Pneumatikanschluss (66) gemäß Anspruch 4 und/oder für den zumindest einen optischen Anschluss (64) gemäß Anspruch 9 gemeinsam angeordnet sind.

11. Prüfsystem nach einem der vorhergehenden Ansprüche, wobei das Basisteil (22) zur Aufnahme von unterschiedlich ausgebildeten Aufsätzen (24) ausgebildet ist, wobei für die verschiedenen Aufsätze (24) ein identisches basisseitiges Schnittstellenteil (20B) ausgebildet ist.

12. Prüfsystem nach einem der vorhergehenden Ansprüche, bei dem ein jeweiliges Prüfmodul (6) mit einer zentralen Versorgungseinrichtung (14) der Prüfvorrichtung (2) über zumindest eine insbesondere drahtgebundene Kommunikationsverbindung sowie bevorzugt zur Druckluftversorgung verbunden ist, und / oder bei dem das Prüfmodul (6) als ein intelligentes Prüfmodul (6) ausgebildet ist, welches selbst zur Erzeugung und Auswertung eines Prüfsignals ausgebildet ist.

13. Prüfsystem nach einem der vorhergehenden Ansprüche, bei dem die Prüfvorrichtung (2) innerhalb einer Montagelinie für eine Kabelsatzfertigung integriert ist.

14. Prüfmodul (6) für ein Prüfsystem nach einem der vorhergehenden Ansprüche, welches modular aufgebaut ist mit einem Basisteil (22) und einem daran über eine Schnittstelle (20) austauschbar befestigten steckerspezifischen Aufsatz (24), wobei
- der Aufsatz (24) aufweist eine steckerspezifische Aufnahme (26), in die ein Stecker (12) einsteckbar ist sowie eine Vielzahl von Prüfkontakten (32) zur elektrischen Prüfung von Leitungen des Kabelsatzes (4),
- das Basisteil (22) aufweist eine Mehrzahl von Testpunktanschlüssen (52), über die für die Prüfung jeweils einer Leitung Prüfsignale bereitgestellt werden sowie eine Steuereinheit (46),
- der Aufsatz (24) und das Basisteil (22) über elektrische Verbindungsleitungen (38) miteinander verbunden sind und wobei
- die Schnittstelle (20) ein basisseitiges Schnittstellenteil (20B) sowie ein aufsatzseitiges Schnittstellenteil (20A) aufweist, über die ein lösbarer elektrischer Steckverbinder (40) für insbesondere sämtliche elektrische Verbindungsleitungen (38) zwischen dem Aufsatz (24) und dem Basisteil (22) bereitgestellt ist.

15. Prüfmodul-Set für ein Prüfsystem nach einem der Ansprüche 1 bis 19 mit einem gemeinsamen Basisteil (22) sowie mit mehreren unterschiedlichen steckerspezifischen Aufsätzen (24), welche jeweils mit dem gemeinsamen Basisteil (22) jeweils über eine Schnittstelle (20) verbunden werden können, wobei
- der jeweilige Aufsatz (24) aufweist eine steckerspezifische Aufnahme (26), in die ein Stecker (12) einsteckbar ist sowie eine Vielzahl von Prüfkontakten (32) zur elektrischen Prüfung von Leitungen des Kabelsatzes (4),
- das Basisteil (22) aufweist eine Mehrzahl von Testpunktanschlüssen (52), über die für die Prüfung jeweils einer Leitung Prüfsignale bereitgestellt werden sowie eine Steuereinheit (46),
- die Schnittstelle (20) ein basisseitiges Schnittstellenteil (20B) sowie ein aufsatzseitiges Schnittstellenteil (20A) aufweist, über die ein lösbarer elektrischer Steckverbinder (40) für insbesondere sämtliche elektrische Verbindungsleitungen (38) zwischen dem Aufsatz (24) und dem Basisteil (22) bereitgestellt ist, wobei das Prüfmodul-Set mehrere unterschiedlich ausgebildete Typen an Basisteilen (22) umfasst, die sich insbesondere im Hinblick auf die Anzahl der Testpunktanschlüsse (52) unterscheiden.
